# EUROPÄISCHE PATENTSCHRIFT

(11) **EP 2 877 658 B1**
(45) Veröffentlichungstag und Bekanntmachung des Hinweises auf die Patenterteilung: **07.11.2018**
(21) Anmeldenummer: 13739999.4
(22) Anmeldetag: 23.07.2013
(51) Int. Cl.: E05B 47/02, E05B 41/00, F16P 3/08, G01R 33/09, E05B 47/00

(54) **ZUGANGSSCHUTZVORRICHTUNG UND EIN VERFAHREN ZUM ÜBERWACHEN EINES ZUSTANDES DER ZUGANGSSCHUTZVORRICHTUNG**
ACCESS PROTECTION DEVICE AND A METHOD FOR MONITORING A STATUS OF THE ACCESS PROTECTION DEVICE
DISPOSITIF DE PROTECTION D'ACCÈS ET PROCÉDÉ DE SURVEILLANCE D'UN ÉTAT DU DISPOSITIF DE PROTECTION D'ACCÈS

(30) Priorität: 24.07.2012 DE 102012106719
(43) Veröffentlichungstag der Anmeldung: 03.06.2015
(73) Patentinhaber: K.A. Schmersal Holding GmbH & Co. KG, 42279 Wuppertal (DE)
(72) Erfinder: KLEES, Christoph, 51674 Wiehl (DE)
(74) Vertreter: Vogel, Andreas
(86) Internationale Anmeldenummer: PCT/EP2013/065484
(87) Internationale Veröffentlichungsnummer: WO 2014/016281

(56) Entgegenhaltungen:
- EP-A1- 1 071 214
- EP-A2- 2 163 713
- EP-A2- 2 295 679
- WO-A1-00/68702
- WO-A2-2009/120894
- DE-U1-202011 103 840
- FR-A3- 2 807 088
- US-A1- 2007 047 152

## Beschreibung

Die vorliegende Erfindung betrifft eine sicherheitsrelevante Zugangsschutzvorrichtung sowie ein Verfahren zum Überwachen zumindest eines Zustandes der Zugangsschutzvorrichtung mit einem verschließbaren Teil, das eine Öffnung aufweist, und einem verschließenden Teil, das einen Riegel aufweist, der zwischen einer Verriegelungsposition und einer Entriegelungsposition bewegbar ist. In der Verriegelungsposition ragt der Riegel in die Öffnung hinein, und der Entriegelungsposition ist der Riegel aus der Öffnung herausgezogen. Dabei weist die Zugangsschutzvorrichtung eine Überwachungsvorrichtung zum Erfassen zumindest eines Zustandes der Zugangsschutzvorrichtung, insbesondere eines Verriegelungszustandes, wenn der Riegel sich in der Verriegelungsposition befindet.

Sichere Erfassung von Verriegelungszuständen ist in verschiedenen Bereichen der Industrie wie Elektromechanik, Optoelektronik, Sensorik und Steuerungstechnik sowie im täglichen Leben ständig gefordert, um Maschinen- und Personensicherheit zu gewährleisten. Beispiele dafür aus der Industrie sind diejenigen Schutzeinrichtungen, die während des Betriebes nicht betreten werden dürfen oder deren Betrieb durch fremde Faktoren leicht gestört werden können. Als Beispiele aus dem täglichen Leben können Aufzugschaltgeräte und Türverriegelungen dienen. Es soll sichergestellt werden, dass bestimmte Räumlichkeiten, sicherheitsrelevante Zugangsschutzvorrichtungen und dergleichen sicher abgeschlossen sind und dass sie ohne Risiko für die Maschinen selbst und für das Personal in Betrieb gebracht werden können. Herkömmliche Zugangsschutzvorrichtungen weisen dabei ein verschließbares Teil und ein verschließendes Teil auf, die mit Hilfe eines Verriegelungselementes des verschließenden Teils verriegelt werden, wobei das Verriegelungselement in eine korrespondierende Öffnung des verschließbaren Teils eingreifen kann. Es sind herkömmliche Überwachungsvorrichtungen wie Positionsschalter oder Lichtschranken und entsprechende Überwachungsverfahren bekannt, um die Position des Verriegelungselementes zu erfassen. Wird dabei festgestellt, dass das Verriegelungselement einer Zugangsschutzvorrichtung seine Verriegelungsposition eingenommen hat, so befindet sich die Vorrichtung im Verriegelungszustand und der Betriebsprozess kann begonnen werden. Die Verriegelungselemente werden üblich in Form von Riegeln ausgeführt, die aus einem verschließenden Teil, beispielsweise einem Türrahmen, herausfahren können und in eine Öffnung eines verschließbaren Teils, beispielsweise einer Tür, eingreifen können, um die Tür eines sicherheitsrelevanten Raumes zu verriegeln. Alternativ können die Riegel am verschließbaren Teil beweglich angeordnet werden und in eine Öffnung im verschließenden Teil einfahren. Oben genannte herkömmliche Vorrichtungen zur Positionsüberwachung des Riegels erzielen zurzeit keine zufriedenstellenden Ergebnisse. Die Sicherheitsanlagen oder Zugangsschutzvorrichtungen sind normalerweise verstärkten Verschmutzungsbedingungen ausgesetzt. Dabei können die Lichtschranken nicht zuverlässig verwendet werden. Die Positionsschalter leisten oft keine sichere Positionserfassung, da die Abstände zwischen den verwendeten Bauteilen aufgrund von Temperaturschwankungen und Materialsetzung stark variieren können.

Es ist daher die Aufgabe der vorliegenden Erfindung, eine Zugangsschutzvorrichtung sowie ein Verfahren zum Überwachen mindestens eines Zustandes der Zugangsschutzvorrichtung bereitzustellen, die eine sichere Erfassung des Zustandes der Zugangsschutzvorrichtung abhängig von der Position des Riegels ermöglichen.

Diese Aufgabe wird mit sämtlichen Merkmalen des unabhängigen Vorrichtungsanspruches sowie des unabhängigen Verfahrensanspruches gelöst. Vorteilhafte Weiterbildungen der Erfindung sind in den abhängigen Ansprüchen angegeben.

Hierzu ist es erfindungsgemäß vorgesehen, dass die Überwachungsvorrichtung einen zweiachsigen Magnetfeldsensor und einen Magnetfeldgeber aufweisen kann, die relativ zueinander bewegt werden können, wobei entweder der Magnetfeldsensor oder der Magnetfeldgeber am Riegel angeordnet sein kann. Durch vorteilhaftes Einsetzen von Magnetelementen in der Überwachungsvorrichtung wird sichergestellt, dass die Positionserfassung berührungslos erfolgt. Mithin entfällt der Bedarf, dass strikte Bauteiltoleranzen eingehalten werden müssen, um einen Schalter betätigen zu können, oder bestimmte Schmutzvorschriften nicht unterschritten werden dürfen, um eine Lichtschranke verwenden zu können.

Gemäß einer Ausführungsalternative der Erfindung kann der Magnetfeldsensor am Riegel des verschließenden Teils angeordnet sein und zusammen mit dem Riegel zwischen einer Verriegelungs- und einer Entriegelungsposition bewegt werden, wobei der Magnetfeldgeber in der Öffnung des verschließbaren Teils angeordnet sein kann. Der Riegel kann erfindungsgemäß linear oder schwenkbar bewegt werden. In einer anderen Ausführungsalternative der Erfindung kann vorgesehen sein, dass der Magnetfeldsensor in der Öffnung des verschließbaren Teils und der Magnetfeldgeber am Riegel des verschließenden Teils angeordnet sind. Das verschließende Teil kann dabei ein Türrahmen oder eine Gehäuseöffnung der Zugangsschutzvorrichtung sein, wobei das verschließbare Teil als eine Tür oder ein Gehäusedeckel der Zugangsschutzvorrichtung ausgebildet sein kann. Alternativ ist es ebenfalls denkbar, dass das das verschließbare Teil als ein Türrahmen bzw. eine Gehäuseöffnung und das verschließende Teil als eine Tür bzw. ein Gehäusedeckel ausgebildet sein können. Der Magnetfeldgeber erzeugt erfindungsgemäß ein Magnetfeld, welches auf den Magnetfeldsensor einwirken kann. Wenn der Riegel zwischen einer herausgezogenen Entriegelungsposition und einer in die Öffnung eingreifenden Verriegelungsposition verfährt, verändert sich dieses Magnetfeld als Funktion der relativen Position des Magnetfeldsensors bzgl. des Magnetfeldgebers.

Erfindungsgemäß kann der Magnetfeldsensor eine Änderung des Magnetfeldes abhängig von der Position des Riegels detektieren. Vorteilhafterweise kann der Magnetfeldsensor als ein zweiachsiger Sensor ausgeführt sein und die Stärke des Magnetfeldes entlang zwei Achsen messen. Die erste Achse kann dabei parallel zur Bewegungsrichtung des Riegels ausgewählt und als eine X-Achse bezeichnet werden. Der Magnetfeldgeber, der als ein Permanentmagnet oder als ein elektrischer Magnet ausgeführt sein kann, kann dabei derart ausgerichtet werden, dass die Magnetisierungsrichtung des Magnetfeldgebers parallel der X-Achse und somit der Bewegungsrichtung des Magnetfeldsensors verläuft. Die zweite Achse des Magnetfeldsensors kann dabei senkrecht zur X-Achse auf einer Linie ausgewählt werden, die die Zentren der Magnetelemente verbindet, wenn sie sich gegenüberstehen, und als eine Y-Achse bezeichnet werden. Die Stärke des Magnetfeldes entlang der X-Achse kann als eine X-Komponente definiert werden. Hierbei erfährt die X-Komponente ein Extremum, wenn sich der Magnetfeldsensor gegenüber dem Magnetfeldgeber befindet. Erfindungsgemäß kann der Magnetfeldgeber derart in der Öffnung des verschließbaren Teils positioniert werden, dass das Extremum der X-Komponente der Verriegelungsposition des Riegels entspricht. In der Verriegelungsposition des Riegels ist eine Y-Komponente des Magnetfeldes, welche entlang der Y-Achse gemessen wird, gleich Null. Wenn also ein Extremum der X-Komponente und ein Nullwert der Y-Komponente durch den Magnetfeldsensor gleichzeitig erfasst werden, kann die Verriegelungsstellung des Riegels sicher detektiert werden. Weiterhin ist zwischen den verwendeten Bauteilen ein Versatz im Raum innerhalb vorgegebener Toleranzen erlaubt.

Gemäß der vorliegenden Erfindung ist der Magnetfeldsensor als ein zweiachsiger AMR-Sensor (anisotrope magnetoresistive Sensor, der auf dem AMR-Effekt beruht) ausgebildet. Vorteilhafterweise wird dabei der anisotrope magnetoresistive Effekt (AMR-Effekt) genutzt, um sicher zu erkennen, wenn der Magnetfeldsensor den Magnetfeldgeber passiert. Erreicht der Riegel seine Verriegelungsposition, so befinden sich die Mittelpunkte des Magnetfeldgebers und des Magnetfeldsensors einander gegenüber. In diesem Punkt erfährt die X-Komponente des Magnetfeldes ein Extremum, wobei die Y-Komponente einen Nullwert passiert. In einer weiteren Ausführungsform der Erfindung kann der Magnetfeldsensor als ein zweiachsiger Hall-Sensor ausgeführt sein.

Der Magnetfeldgeber kann als ein Permanentmagnet oder als ein elektrischer Magnet ausgebildet sein. Dabei kann der Magnetfeldgeber ein bestimmtes Magnetfeld erzeugen, welches auf einen relativ zum Magnetfeldgeber bewegbaren Magnetfeldsensor wirken kann. Auf den Magnetfeldsensor wirkt somit stets eine magnetische Kraft, die tangential zu der Magnetfeldlinie ausgerichtet ist, die durch den Punkt verläuft, in welchem der Magnetfeldsensor positioniert ist. Diese magnetische Kraft kann dabei als eine Summe der X-Komponente und der Y-Komponente dargestellt werden, wobei die X-Komponente parallel der Bewegungsrichtung des Riegels gemessen wird und wobei die Y-Komponente je nach Position des Riegels bzgl. des Magnetfeldgebers eine Anziehungskraft oder eine Abstoßkraft auf den Magnetfeldsensor ausübt. Wenn der Riegel sich in der Entriegelungsposition befindet, ist der Magnetfeldsensor am weitesten vom Magnetfeldgeber entfernt. In dieser Position wirkt auf den Magnetfeldsensor eine magnetische Kraft, die durch eine X-Komponente und eine Y-Komponente dargestellt werden kann. Verlässt der Riegel die Entriegelungsposition, verändern sich die Magnetfeldkomponenten bis die X-Komponente in der Entriegelungsposition ein Extremum und die Y-Komponente einen Symmetriepunkt in der Verriegelungsposition durchläuft. Erfindungsgemäß sollen die Länge des Weges des Riegels, die Position des Magnetfeldgebers und/oder die Stärke des Magnetfeldes derart ausgewählt werden, damit die Y-Komponente auf der Länge des Weges des Riegels zumindest ein Maximum oder ein Minimum erfährt, um den Symmetriepunkt der Y-Komponente zuverlässig erkennen zu können.

Erfindungsgemäß ist es wesentlich, die Veränderung beider Komponenten des Magnetfeldes zu erfassen, um mögliche Messfehler durch Einfluss von externen Magnet- oder Temperatur-Störfeldern ausschließen zu können. Wird nur eine der Komponenten gemessen, so können solche Fremdfelder die gemessene Kurve verschieben, sodass die Verriegelungsposition nicht sicher erkannt werden kann. Werden jedoch beide Komponenten des Magnetfeldes gemessen, so können zwar beide Kurven verschoben werden, ein charakteristischer Punkt der beiden Kurven bleibt aber erhalten. Der charakteristische Punkt ist erfindungsgemäß dadurch definiert, dass in diesem Punkt die X-Komponente ein Extremum erfährt und die Y-Komponente einen Symmetriepunkt durchläuft. Dieser Punkt ist vorteilhafterweise ein sicherer Indikator dafür, dass sich der Riegel in der Verriegelungsposition befindet. Durch die Messung von zwei Komponenten wird somit sichergestellt, dass externe Felder sowie Manipulationen durch Fremdmagnete bis zu einer bestimmten Stärke die sichere Erfassung des charakteristischen Punktes und somit der Verriegelungsposition des Riegels nicht beeinflussen können.

Ferner kann vorgesehen sein, dass die erfindungsgemäße Überwachungsvorrichtung eine Anzeigeeinheit zum Darstellen einer Änderung des Magnetfeldes abhängig von der Position des Riegels aufweist. Die Anzeigeeinheit kann dabei die Magnetfeldkomponenten in Abhängigkeit von der Position des Riegels als Kurven visualisieren. Vorteilhafterweise kann die Anzeigeeinheit ein skaliertes Feld mit zwei senkrechten Achsen in die X-Richtung und in die Y-Richtung aufweisen, dessen Schnittpunkt dem charakteristischen Punkt der beiden Kurven in der Abwesenheit von zufälligen oder manipulativen Störfeldern entspricht. In dem charakteristischen Punkt weist die X-Komponente erfindungsgemäß ein Extremum und die Y-Komponente einen Symmetriepunkt, wobei der Riegel sich in diesem Punkt in der Verriegelungsposition befindet, auf. Bei Präsenz von Magnet- oder Temperatur-Störfeldern kann der charakteristische Punkt aus dem Mittelpunkt der Anzeigeeinheit verschoben werden, jedoch wird dieser Punkt selbst dann ein sicherer Indikator der Verriegelungsposition des Riegels und somit des Verriegelungszustandes der sicherheitsrelevanten Zugangsschutzvorrichtung.

Ferner kann die Überwachungsvorrichtung eine Auswerteeinheit zum Berechnen des Magnetfeldes abhängig von der Position des Riegels aufweisen. Die Auswerteeinheit kann dabei den charakteristischen Punkt der beiden Kurven berechnen und die Position des Riegels melden, die der Verriegelungsposition des Riegels entspricht.

Die Erfindung schließt ein Verfahren zum Überwachen mindestens eines Zustandes einer sicherheitsrelevanten Zugangsschutzvorrichtung ein, wobei die Zugangsschutzvorrichtung ein verschließendes Teil, insbesondere einen Türrahmen oder eine Wand, mit einem Riegel und ein verschließbares Teil, insbesondere eine Tür, mit einer Öffnung aufweist. Vorteilhafterweise kann der Riegel zwischen einer Verriegelungsposition und einer Entriegelungsposition bewegt werden, wobei in der Verriegelungsposition der Riegel in die Öffnung hineinragt, und in der Entriegelungsposition der Riegel aus der Öffnung herausgezogen ist. Dabei kann der Riegel annährend linear oder schwenkbar bewegt werden. Ferner kann die Zugangsschutzvorrichtung mit einer Überwachungsvorrichtung ausgeführt werden, die dazu ausgelegt ist, zumindest einen Zustand der Zugangsschutzvorrichtung, insbesondere einen Verriegelungszustand, zu erkennen, wenn der Riegel sich in der Verriegelungsposition befindet. Erfindungsgemäß ist vorgesehen, dass die Überwachungsvorrichtung einen zweiachsigen AMR-Magnetfeldsensor und einen Magnetfeldgeber aufweist, die sich relativ zueinander bewegen, wobei der Magnetfeldsensor oder der Magnetfeldgeber sich mit dem Riegel bewegt, und dass der Magnetfeldsensor eine Änderung des Magnetfeldes abhängig von der Position des Riegels erfassen kann.

Erfindungsgemäß kann der Magnetfeldgeber ein Magnetfeld erzeugen, welches auf den Magnetfeldsensor mit unterschiedlicher Magnetfeldstärke abhängig von der Position des Riegels einwirkt. Vorteilhafterweise kann der Magnetfeldsensor eine Änderung einer X-Komponente des Magnetfeldes in eine Richtung erfassen, die sich parallel zur Bewegungsrichtung des Riegels erstreckt, und eine Änderung einer Y-Komponente des Magnetfeldes in eine Richtung erfassen, die sich senkrecht zur Bewegungsrichtung des Riegels erstreckt. Die X-Komponente und die Y-Komponente des Magnetfeldes variieren dabei in Abhängigkeit von der Position des Magnetfeldsensors. Die Kurve, die dabei die Y-Komponente bildet, ähnelt einer Sinusschwingung. Wenn der Riegel die Entriegelungsposition in die Richtung zur Verriegelungsposition verlässt, verändert sich die Y-Komponente zunächst monoton bis zu einem Extremum, wobei die Y-Komponente nach dem Extremum sich monoton in eine andere Richtung bis zu einem Symmetriepunkt entwickelt, und läuft schließlich ab dem Symmetriepunkt zu einem entgegengesetzten spiegelsymmetrischen Extremum hinaus. Der Symmetriepunkt der Y-Komponente entspricht erfindungsgemäß der Verriegelungsposition des Riegels. Der Verlauf der X-Komponente ähnelt der Funktion einer Gauß-Verteilung und weist dabei ein Extremum in der Verriegelungsposition des Riegels auf.

Erfindungsgemäß kann die Überwachungsvorrichtung eine Verriegelungsposition des Riegels detektieren, wenn ein Extremum der X-Komponente und ein Symmetriepunkt der Y-Komponente, insbesondere gleichzeitig, detektiert werden. Vorteilhafterweise kann somit sichergestellt werden, dass die Position des Magnetfeldsensors gegenüber dem Magnetfeldgeber tatsächlich der Verriegelungsposition des Riegels entspricht. Die fremden Magnet- oder Temperaturfelder können dazu führen, dass nur eine gemessene Komponente verschoben werden kann oder gar ein fremdes Extremum mit dem gesuchten verwechselt werden kann. Wenn allerdings zwei Komponenten gleichzeitig gemessen werden, können die Komponenten zwar verschoben werden, jedoch nicht der charakteristische Punkt der Messung gespaltet werden, in welchem ein Extremum der X-Komponente und ein Symmetriepunkt der Y-Komponente erfasst werden. Mithin kann bis zu einer gewissen Stärke der Störung sichergestellt werden, dass die Verriegelungsposition des Riegels zuverlässig erkannt wird. Ebenfalls ist es denkbar, dass die Überwachungsvorrichtung jederzeit anhand einer Änderung der X-Komponente und einer Änderung der Y-Komponente die Position des Magnetfeldsensors bzgl. des Magnetfeldgebers erfassen kann. Ferner kann vorgesehen sein, dass eine erste Messung vorgenommen wird, um die Überwachungsvorrichtung zu justieren. Hierbei kann die Verriegelungsposition des Riegels als ein Bezugspunkt verwendet werden. Anschließend kann jegliche Position des Riegels zwischen der Entriegelungsposition und Verriegelungsposition zuverlässig mit der gefundenen Verriegelungsposition verglichen werden.

Erfindungsgemäß kann vorgesehen sein, dass die Überwachungsvorrichtung eine Änderung der X-Komponente und/oder eine Änderung der Y-Komponente mit charakteristischen Daten vergleichen kann, um mögliche Abweichungen festzustellen. Die charakteristischen Daten können beispielsweise in einer ersten Messung als Referenzwerte abgespeichert werden. Dabei kann die Überwachungsvorrichtung justiert werden. Alternativ ist es denkbar, dass die Überwachungsvorrichtung ein vorgegebenes Set charakteristischer Daten für den entsprechenden Magnetfeldsensor aufweisen kann. Durch Vergleichen der gemessenen Daten mit den charakteristischen Daten kann festgestellt werden, ob Fremdfelder die Messung beeinflusst haben. Wenn fremde Magnetfelder die Überwachung stören, können die gemessenen Komponenten abhängig von der Position des Riegels verschoben werden, wobei jedoch der charakteristische Punkt der beiden Komponenten dennoch sicher auf die Verriegelungsposition des Riegels verweist. Die Größe der Verschiebung kann dabei einen Aufschluss über die Stärke des Störfeldes geben. Wird die Überwachungsvorrichtung Temperaturänderungen ausgesetzt, so können Amplituden der gemessenen Magnetfeldkomponenten von den charakteristischen Daten abweichen, aber auch in diesem Fall bleibt der charakteristische Punkt ein sicherer Hinweis für die Verriegelungsposition des Riegels.

Erfindungsgemäß können die Merkmale der Beschreibung der erfindungsgemäßen Zugangsschutzvorrichtung sowie des erfindungsgemäßen Verfahrens in den verschiedensten Kombinationen kombiniert werden. Weitere, die Erfindung verbessernde Maßnahmen werden nachstehend gemeinsam mit der Beschreibung des bevorzugten Ausführungsbeispieles der Erfindung anhand der Figuren näher dargestellt. Es zeigen:
- Fig. 1: Eine schematische Darstellung einer erfindungsgemäßen Zugangsschutzvorrichtung,
- Fig. 2: eine vergrößerte Ansicht der erfindungsgemäßen Zugangsschutzvorrichtung aus Figur 1,
- Fig. 3: eine perspektivische Ansicht eines Magnetfeldgebers und eines Magnetfeldsensors,
- Fig. 4: eine schematische Ansicht der Magnetfeldlinien eines magnetischen Feldes, welches durch den Magnetfeldgeber erzeugt wird und auf den darin bewegbaren Magnetfeldsensor einwirkt, und
- Fig. 5: Funktionen der auf den Magnetfeldsensor einwirkenden Kräfte abhängig von der Position des Magnetfeldsensors im Feld des Magnetfeldgebers entlang der X-Achse aus Figur 4.

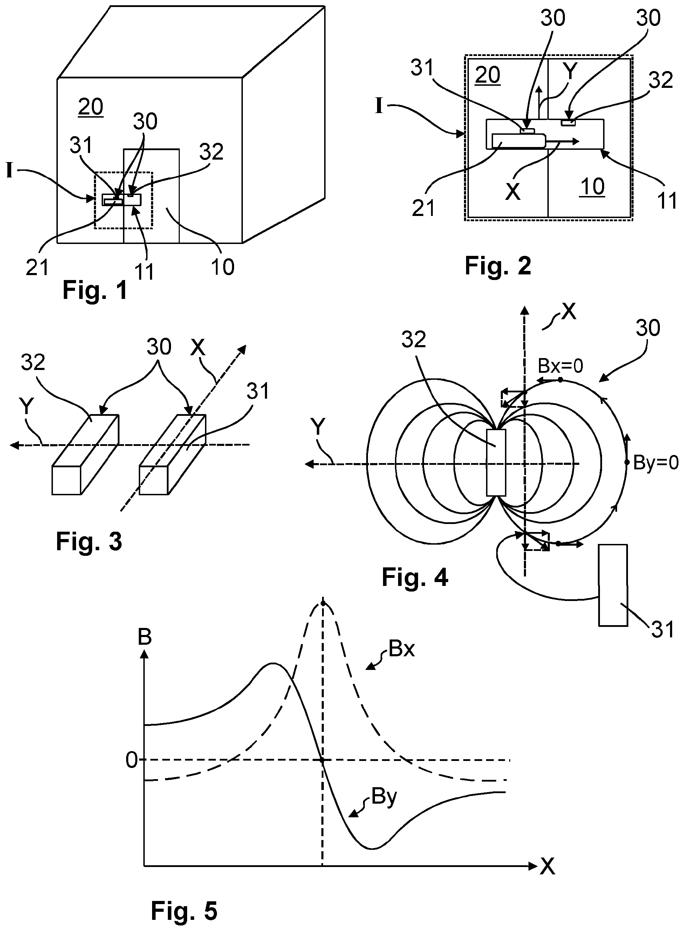

Figur 1 zeigt ein Beispiel einer erfindungsgemäßen Zugangsschutzvorrichtung, welche ein verschließbares Teil 10 und ein verschließendes Teil 20 aufweist. Das verschließbare Teil 10 ist dabei als eine Tür und das verschließende Teil 20 als ein Türrahmen in der Wand der sicherheitsrelevanten Zugangsschutzvorrichtung dargestellt. Der verschließbare Teil 10 ist mit einer Öffnung 11 und das verschließende Teil 20 mit einem beweglich gelagerten Riegel 21 ausgeführt. Der Riegel 21 ist dabei zwischen einer Verriegelungsposition und einer Entriegelungsposition linear bewegbar, wobei in der Verriegelungsposition der Riegel 21 in die Öffnung 11 hineinragt, und der Entriegelungsposition der Riegel 21 aus der Öffnung 11 herausgezogen ist. Ferner weist die Zugangsschutzvorrichtung eine Überwachungsvorrichtung 30 zum Erfassen zumindest eines Zustandes der Zugangsschutzvorrichtung, insbesondere eines Verriegelungszustandes auf, wenn der Riegel 21 sich in der Verriegelungsposition befindet. Die erfindungsgemäße Überwachungsvorrichtung 30 weist ferner einen zweiachsigen Magnetfeldsensor 31 und einen Magnetfeldgeber 32 auf.

Eine vergrößerte Ansicht der erfindungsgemäßen Zugangsschutzvorrichtung ist in Figur 2 dargestellt. Dabei ist der Magnetfeldsensor 31 am Riegel 21 des verschließenden Teils 20 angeordnet und ist mit diesem annähernd linear zwischen einer Verriegelungsposition und einer Entriegelungsposition entlang der X-Achse bewegbar. Der Magnetfeldgeber 32 ist dabei in der Öffnung 11 des verschließbaren Teils vorgesehen. Der Magnetfeldgeber 32 erzeugt erfindungsgemäß ein Magnetfeld, welches auf den Magnetfeldsensor 31 einwirken kann. Die Magnetfeldlinien des erzeugten Magnetfeldes sind schematisch in der Figur 4 gezeigt. Wenn der Riegel 21 zwischen einer herausgezogenen Entriegelungsposition und einer in die Öffnung 11 eingreifenden Verriegelungsposition bewegt wird, verändert sich das Magnetfeld als Funktion der relativen Position des Riegels 21 bzgl. der Öffnung 11. Der Magnetfeldsensor 31 ist dazu ausgelegt, die Änderung des Magnetfeldes abhängig von der Position des Riegels 21 zu detektieren. Der Magnetfeldsensor 31 ist gemäß Figur 4 als ein zweiachsiger AMR-Sensor ausgebildet, welcher die Stärke des Magnetfeldes entlang zwei Achsen messen kann. Die Achse X entspricht der Bewegungsrichtung des Riegels 21 aus der Entriegelungsposition in die Verriegelungsposition, wie in der Figur 2 gezeigt ist. Der Magnetfeldgeber 32 kann erfindungsgemäß entweder als ein Permanentmagnet oder als ein elektrischer Magnet ausgeführt sein. Wie in der Figur 3 gezeigt ist, sind der Magnetfeldgeber 32 und der Magnetfeldsensor 31 derart ausgerichtet, dass die Magnetisierungsrichtung des Magnetfeldgebers 32 parallel der Magnetisierungsrichtung des Magnetfeldsensors 31 sowie parallel der X-Achse ausgerichtet ist. Die zweite Achse des Magnetfeldsensors 32 kann dabei senkrecht zur X-Achse ausgewählt werden, die gemäß Figur 3 vom Zentrum des Magnetfeldsensors 31 zum Zentrum des Magnetfeldgebers 32 gerichtet ist, wenn sich der Magnetfeldsensor 31 und der Magnetfeldgeber 32 gegenüberstehen.

Figur 4 zeigt ferner, wie die Flußdichte (gemessen in B [mT]), welche proportional zur erzeugten magnetischen Kraft ist, die auf den Magnetsensor 31 im Magnetfeld des Magnetfeldgebers 32 einwirkt, in eine X-Komponente und eine Y-Komponente zerlegt werden kann. Zudem ist in der Figur 4 zu erkennen, dass die X-Komponente ein Maximum aufweist, wenn der Magnetfeldsensor 31 sich gegenüber dem Magnetfeldgeber 32 befindet. Erfindungsgemäß entspricht dieser Punkt der Verriegelungsposition des Riegels 21. In der Verriegelungsposition des Riegels 21 ist gleichzeitig die Y-Komponente des Magnetfeldes, welche entlang der Y-Achse gemessen wird, gleich Null. Ein Maximum der X-Komponente und ein Nullwert der Y-Komponente weisen erfindungsgemäß daraufhin, dass der Riegel 21 sich in der Verriegelungsstellung befindet. Der Magnetfeldsensor 32 ist gemäß Figuren 4 und 5 als ein zweiachsiger AMR-Sensor ausgebildet, welcher den anisotropen magnetoresistiven Effekt nutzt, um zwei Magnetfeldkomponenten zu erkennen, die auf den Magnetfeldsensor 31 in die X-Richtung und in die Y-Richtung wirken. Alternativ ist es denkbar, dass der Magnetfeldsensor 31 als ein zweiachsiger Hall-Sensor ausgeführt sein kann.

In Figur 4 ist das Magnetfeld des Magnetfeldgebers 32 mit Hilfe von gezeichneten Magnetfeldlinien dargestellt. Die magnetische Kraft, die auf den Magnetfeldsensor 31 wirkt, variiert dabei, wenn der Magnetfeldsensor 31 entlang der X-Achse bewegt wird. Die magnetische Kraft wirkt tangential zu der Magnetfeldlinie, die durch den Punkt verläuft, in welchem der Magnetfeldsensor 31 sich befindet. Diese magnetische Kraft ist dabei als eine Summe der X-Komponente und der Y-Komponente dargestellt, wobei die X-Komponente parallel der Bewegungsrichtung des Riegels 21 gezeichnet ist und die Y-Komponente unterhalb des Magnetfeldgebers 32 abstoßend und oberhalb des Magnetfeldgebers 32 anziehend auf den Magnetfeldsensor 31 wirkt.

Figur 5 zeigt die X- und Y-Komponente des Magnetfeldes als Funktion der Position des Riegels 21 mit einer gestrichelten bzw. mit einer durchgezogenen Linie in einem Koordinatensystem, bei welchem auf der horizontalen Achse die Position des Magnetfeldsensors 31 bzgl. des Magnetfeldgebers 32 und auf der vertikalen Achse die Stärke des Magnetfeldes angegeben ist. Wenn der Riegel 21 entlang der X-Achse, wie gezeigt in Figur 4, bewegt wird, verfährt die Y-Komponente eine Sinus-ähnliche Schwingung und die Funktion der X-Komponente eine Gauß-ähnliche Kuppel. Dabei wächst zunächst die Y-Komponente monoton bis zu einem Maximum, fällt nach dem Maximum monoton ab, durchläuft dabei einen Symmetriepunkt, und fällt weiter bis zu einem Minimum. Der Symmetriepunkt der Y-Komponente entspricht erfindungsgemäß dem Maximum der X-Komponente und vorteilhafterweise der Verriegelungsposition des Riegels 21. Dieser Funktionsverlauf entspricht einer Ausrichtung der Magnetisierungsrichtung des Magnetfeldsensors 31 und der Magnetisierungsrichtung des Magnetfeldgebers 32 in die gleiche Richtung entlang der X-Achse. Werden der Magnetfeldsensor 31 und der Magnetfeldsensor 32 derart ausgerichtet, dass die Magnetisierungsrichtungen entgegengesetzt sind, so wird der Funktionsverlauf der Kurven in Figur 5 bzgl. der Linie B=0 spiegelsymmetrisch nach unten abgebildet.

Der wesentliche Erfindungsgedanke liegt dabei darin, dass zwei Komponenten des Magnetfeldes gemessen werden. Wenn nur eine der Komponenten gemessen wird, kann die Messung durch Fremdfelder gestört werden, da die einzelne Kurve verschoben werden kann, sodass die Verriegelungsposition des Riegels 21 nicht sicher erkannt werden kann. Die Erfindung geht von dem Gedanken aus, dass zwei Komponenten des Magnetfeldes gemessen werden, um die Verriegelungsposition des Riegels 21 sicher zu erkennen, die dadurch gekennzeichnet ist, dass der charakteristische Punkt beider Kurven, in welchem die X-Komponente ein Extremum erfährt und die Y-Komponente einen Symmetriepunkt durchläuft, erhalten bleibt. Dieser Punkt stellt einen sicheren Hinweis auf die Verriegelungsposition des Riegels 21 dar. Durch die Messung zweier Komponenten kann bis zu einer gewissen Stärke der Störfelder, sei es Magnet- oder Temperaturfelder, sichergestellt werden, dass die Verriegelungsposition des Riegels 21 trotzdem erkannt wird.

Die erfindungsgemäße Überwachungsvorrichtung kann ferner mit einer nicht in den Figuren dargestellten Anzeigeeinheit ausstattet sein, die den Funktionsverlauf gemäß Figur 5 visualisieren kann. Die Anzeigeeinheit kann dabei auf den charakteristischen Punkt in Abwesenheit der Störfelder skaliert werden. Ferner kann die Überwachungsvorrichtung mit einer Auswerteinheit zum Berechnen des Magnetfeldes abhängig von der Position des Riegels ausgestattet sein. In der Überwachungsvorrichtung kann ein Set charakteristischer Daten gespeichert werden, um die gemessenen Daten mit den gespeicherten zu vergleichen. Weicht der gemessene charakteristische Punkt von dem vorgegebenen ab, so kann die Größe der Abweichung ein Indikator für die Stärke des Störfeldes sein. Werden die Amplituden der gemessenen Kurven verschoben, so kann eine Temperaturschwankung festgestellt werden. Allerdings beeinflussen weder die Temperaturänderungen noch magnetischer Störfelder bis zu einem gewissen Grad nicht den charakteristische Punkt, in welchem die X-Komponente ein Extremum und die Y-Komponente ein Symmetriepunkt gleichzeitig aufweisen, der einen sicheren Hinweis auf die Verriegelungsposition des Riegels darstellt.

Es sollte einem Fachmann naheliegen, dass sich die Erfindung in ihrer Ausführung nicht auf das vorstehend angegebene bevorzugte Ausführungsbeispiel beschränkt. Vielmehr können Merkmale aus Figuren 1 bis 5 miteinander und/oder mit den Merkmalen aus der Beschreibung und/oder mit den Merkmalen aus den Ansprüchen beliebig kombiniert werden. Beispielhaft ist es denkbar, dass das verschließbare Teil nicht die Tür sondern der Türrahmen ist und dass das verschließende Teil die Tür ist. Ebenfalls ist es möglich, dass der Magnetfeldsensor unbeweglich in der Öffnung angeordnet sein kann, wobei der Magnetfeldgeber mit dem Riegel bewegt werden kann.

### Bezugszeichenliste

- 10: verschließbares Teil
- 11: Öffnung

- 20: verschließendes Teil
- 21: Riegel

- 30: Überwachungsvorrichtung
- 31: Magnetfeldsensor
- 32: Magnetfeldgeber

- Bx: X-Komponente des Magnetfeldes
- By: Y-Komponente des Magnetfeldes

## Patentansprüche

1. Zugangsschutzvorrichtung mit
einem verschließbaren Teil (10), das eine Öffnung (11) aufweist,
einem verschließenden Teil (20), das einen Riegel (21) aufweist, der zwischen einer Verriegelungsposition und einer Entriegelungsposition bewegbar ist,
wobei in der Verriegelungsposition der Riegel (21) in die Öffnung (11) hineinragt, und in der Entriegelungsposition der Riegel (21) aus der Öffnung (11) herausgezogen ist, und
einer Überwachungsvorrichtung (30) zum Erfassen zumindest eines Zustandes der Zugangsschutzvorrichtung, insbesondere eines Verriegelungszustandes, wenn der Riegel (21) sich in der Verriegelungsposition befindet,
**dadurch gekennzeichnet,**
**dass** die Überwachungsvorrichtung (30) einen zweiachsigen Magnetfeldsensor (31) und einen Magnetfeldgeber (32) aufweist, die relativ zueinander bewegbar sind, wobei der Magnetfeldsensor (31) oder der Magnetfeldgeber (32) mit dem Riegel (21) bewegbar ist, wobei der Magnetfeldsensor (31) ein AMR-Sensor ist, um sicher zu erkennen, wenn der Magnetfeldsensor (31) den Magnetfeldgeber (32) passiert.

2. Zugangsschutzvorrichtung nach Anspruch 1,
**dadurch gekennzeichnet,**
**dass** der Magnetfeldgeber (32) zur Messung der Stärke des Magnetfeldes entlang zwei Achsen ausgeführt ist, um mögliche Messfehler ausschließen zu können, wobei insbesondere der Magnetfeldgeber (32) ein Permanentmagnet ist.

3. Zugangsschutzvorrichtung nach einem der vorgenannten Ansprüche,
**dadurch gekennzeichnet,**
**dass** der Magnetfeldsensor (31) am Riegel (21) des verschließenden Teils (20) und der Magnetfeldgeber (32) in der Öffnung (11) des verschließbaren Teils (10) angeordnet sind.

4. Zugangsschutzvorrichtung nach einem der vorgenannten Ansprüche,
**dadurch gekennzeichnet,**
**dass** die Überwachungsvorrichtung (30) eine Anzeigeeinheit zum Darstellen einer Änderung des Magnetfeldes abhängig von der Position des Riegels (21) aufweist.

5. Zugangsschutzvorrichtung nach einem der vorgenannten Ansprüche,
**dadurch gekennzeichnet,**
**dass** die Überwachungsvorrichtung (30) eine Auswerteinheit zum Berechnen des Magnetfeldes abhängig von der Position des Riegels (21) aufweist.

6. Verfahren zum Überwachen mindestens eines Zustandes einer sicherheitsrelevanten Zugangsschutzvorrichtung nach einem der Ansprüche 1-5 mit einem verschließbaren Teil (10), das eine Öffnung (11) aufweist,
einem verschließenden Teil (20), das einen Riegel (21) aufweist, der zwischen einer Verriegelungsposition und einer Entriegelungsposition bewegt wird,
wobei in der Verriegelungsposition der Riegel (21) in die Öffnung (11) hineinragt, und in der Entriegelungsposition der Riegel (21) aus der Öffnung (11) herausgezogen ist, und
einer Überwachungsvorrichtung (30), die zumindest einen Zustand der Zugangsschutzvorrichtung, insbesondere einen Verriegelungszustand erfasst, wenn der Riegel (21) sich in der Verriegelungsposition befindet,
**dadurch gekennzeichnet,**
**dass** die Überwachungsvorrichtung (30) einen zweiachsigen AMR-Magnetfeldsensor (31) und einen Magnetfeldgeber (32) aufweist, die sich relativ zueinander bewegen, wobei der Magnetfeldsensor (31) oder der Magnetfeldgeber (32) sich mit dem Riegel (21) bewegt,
und **dass** der Magnetfeldsensor (31) eine Änderung des Magnetfeldes abhängig von der Position des Riegels (21) erfasst.

7. Verfahren nach Anspruch 6,
**dadurch gekennzeichnet,**
**dass** der Magnetfeldsensor (31) eine Änderung einer X-Komponente des Magnetfeldes in eine Richtung erfasst, die sich parallel zur Bewegungsrichtung des Riegels (21) erstreckt, und eine Änderung einer Y-Komponente des Magnetfeldes in eine Richtung erfasst, die sich senkrecht zur Bewegungsrichtung des Riegels (21) erstreckt.

8. Verfahren nach Anspruch 7,
**dadurch gekennzeichnet,**
**dass** die Überwachungsvorrichtung (30) eine Verriegelungsposition des Riegels (21) erfasst, wenn ein Extremum der X-Komponente und ein Symmetriepunkt der Y-Komponente detektiert werden.

9. Verfahren nach einem der Ansprüche 6 bis 8,
**dadurch gekennzeichnet,**
**dass** die Überwachungsvorrichtung (30) anhand einer Änderung der X-Komponente und/oder einer Änderung der Y-Komponente die Position des Magnetfeldsensors (31) bzgl. des Magnetfeldgebers (32) erfasst.

10. Verfahren nach einem der Ansprüche 6 bis 9,
**dadurch gekennzeichnet,**
**dass** die Überwachungsvorrichtung (30) eine Änderung der X-Komponente und/oder eine Änderung der Y-Komponente mit charakteristischen Daten vergleicht, um Abweichungen festzustellen.

11. Verfahren nach Anspruch 10,
**dadurch gekennzeichnet,**
**dass** die Überwachungsvorrichtung Fremdfelder detektiert, wenn die gemessenen Magnetfeldkomponenten abhängig von der Position des Riegels (21) von charakteristischen Daten abweichen.

12. Verfahren nach Anspruch 10 oder 11,
**dadurch gek nnzeichnet,**
dass die Überwachungsvorrichtung Temperaturänderungen in der Zugangsschutzvorrichtung detektiert, wenn die Amplituden der gemessenen Magnetfeldkomponenten von den charakteristischen Daten abweichen.

13. Verfahren nach einem der Ansprüche 6 bis 12 zum Betreiben einer Zugangsschutzvorrichtung nach einem der Ansprüche 1 bis 5.

## Claims

1. Access protection device with
a closeable part (10), which comprises an opening (11),
a closing part (20), which comprises a lock (21), which is moveable between a locking position and an unlocking position,
wherein, in the locking position, the lock (21) protrudes into the opening (11), and, in the unlocking position, the lock (21) is pulled out of the opening (11), and
a monitoring device (30) to detect at least one state of the access protection device, in particular a locking state, if the lock (21) is located in the locking position,
**characterized in that**
the monitoring device (30) comprises a biaxial magnetic field sensor (31) and a magnetic field generator (32), which are moveable relative to one another, wherein the magnetic field sensor (31) or the magnetic field generator (32) is moveable with the lock (21), wherein the magnetic field sensor (31) is an AMR sensor, in order to surely be able to detect when the magnetic field sensor (31) passes the magnetic field generator (32).

2. Access protection device according to claim 1,
**characterized in that**
the magnetic field generator (32) is configured to measure the strength of the magnetic field along two axes in order to be able to exclude possible measurement errors, wherein in particular the magnetic field generator (32) is a permanent magnet.

3. Access protection device according to one of the preceding claims,
**characterized in that**
the magnetic field sensor (31) is arranged on the lock (21) of the closing part (20), and the magnetic field generator (32) is arranged in the opening of the closeable part (10).

4. Access protection device according to one of the preceding claims,
**characterized in that**
the monitoring device (30) comprises a display unit for representing a change of the magnetic field dependent upon the position of the lock (21).

5. Access protection device according to one of the preceding claims,
**characterized in that**
the monitoring device (30) comprises an evaluation unit for calculating the magnetic field dependent upon the position of the lock (21).

6. Method for monitoring at least one state of a security-relevant access protection device according to one of the claims 1-5 with
a closeable part (10), which comprises an opening (11),
a closing part (20), which comprises a lock (21), which is moved between a locking position and an unlocking position,
wherein, in the locking position, the lock (21) protrudes into the opening (11), and, in the unlocking position, the lock (21) is pulled out of the opening (11), and
a monitoring device (30), which detects at least one state of the access protection device, in particular a locking state, if the lock (21) is in the locking position,
**characterized in that**
the monitoring device (30) comprises a biaxial AMR magnetic-field sensor (31) and a magnetic field generator (32), which move relative to one another, wherein the magnetic field sensor (31) or the magnetic field generator (32) moves with the lock (21),
and that the magnetic field sensor (31) detects a change of the magnetic field, dependent upon the position of the lock (21).

7. Method according to claim 6,
**characterized in that**
the magnetic field sensor (31) detects a change of an X-component of the magnetic field in a direction, which extends parallel to the direction of movement of the lock (21), and detects a change of a Y-component of the magnetic field in a direction, which extends perpendicular to the direction of movement of the lock (21).

8. Method according to claim 7,
**characterized in that**
the monitoring device (30) detects a locking position of the lock (21) if an extremum of the X-component and a point of symmetry of the Y-component are detected.

9. Method according to one of claims 6 to 8,
**characterized in that**
the monitoring device (30), based on a change of the X-component and/or a change of the Y-component, detects the position of the magnetic field sensor (31) with respect to the magnetic field generator (32).

10. Method according to one of claims 6 to 9,
**characterized in that**
the monitoring device (30) compares a change of the X-component and/or a change of the Y-component with characteristic data, in order to determine deviations.

11. Method according to claim 10,
**characterized in that**
the monitoring device detects external fields if the measured magnetic field components, dependent upon the position of the lock (21), deviate from characteristic data.

12. Method according to claims 10 or 11,
**characterized in that**
the monitoring device detects temperature changes in the access protection device if the amplitudes of the measured magnetic field components deviate from the characteristic data.

13. Method according to one of claims 6 to 12 for operating an access protection device according to one of claims 1 to 5.

## Revendications

1. Dispositif de protection d'accès avec
une partie (10) pouvant être fermée et comportant une ouverture (11),
une partie (20) fermant et comportant un verrou (21) qui est déplaçable entre une position de verrouillage et une position de déverrouillage,
le verrou (21) faisant saillie dans l'ouverture (11) lorsqu'il est en position de verrouillage et le verrou (21) étant retiré de l'ouverture (11) dans la position de déverrouillage, et
un dispositif de surveillance (30) pour détecter au moins un état du dispositif de protection d'accès, en particulier un état de verrouillage, lorsque le verrou (21) se trouve dans la position de verrouillage,
**caractérisé en ce que**
le dispositif de surveillance (30) comporte un capteur de champ magnétique (31) biaxial et un générateur de champ magnétique (32) qui sont déplaçables l'un par rapport à l'autre, le capteur de champ magnétique (31) ou le générateur de champ magnétique (31) avec le verrou (21) étant déplaçable, le capteur de champ magnétique (31) étant un capteur AMR afin de détecter fiablement lorsque le capteur de champ magnétique (31) franchit le générateur de champ magnétique (32).

2. Dispositif de protection d'accès selon la revendication 1,
**caractérisé en ce que**
le générateur de champ magnétique (32) est conçu pour mesurer l'intensité du champ magnétique le long de deux axes afin de pouvoir exclure d'éventuelles erreurs de mesure, le générateur de champ magnétique (32) en particulier étant un aimant permanent.

3. Dispositif de protection d'accès selon l'une quelconque des revendications précédentes,
**caractérisé en ce que**
le capteur de champ magnétique (31) est disposé sur le verrou (21) de la partie (20) assurant la fermeture et le générateur de champ magnétique (32) dans l'ouverture (11) de la partie (10) pouvant être fermée.

4. Dispositif de protection d'accès selon l'une quelconque des revendications précédentes,
**caractérisé en ce que**
le dispositif de surveillance (30) comporte une unité d'affichage pour afficher une variation du champ magnétique en fonction de la position du verrou (21).

5. Dispositif de protection d'accès selon l'une quelconque des revendications précédentes,
**caractérisé en ce que**
le dispositif de surveillance (30) comporte une unité d'évaluation pour calculer le champ magnétique en fonction de la position du verrou (21).

6. Procédé de surveillance d'au moins un état d'un dispositif de protection d'accès pertinent pour la sécurité selon l'une quelconque des revendications 1 à 5 comprenant
une partie (10) pouvant être fermée et comportant une ouverture (11), une partie (20) fermant et comportant un verrou (21) mobile entre une position de verrouillage et une position de déverrouillage,
le verrou (21) faisant saillie dans l'ouverture (11) lorsqu'il est en position de verrouillage et le verrou (21) étant retiré de l'ouverture (11) dans la position de déverrouillage, et
un dispositif de surveillance (30) qui enregistre au moins un état du dispositif de protection d'accès, en particulier un état de verrouillage, lorsque le verrou (21) se trouve en position de verrouillage,
**caractérisé en ce que**
le dispositif de surveillance (30) comporte un capteur de champ magnétique AMR (31) biaxial et un générateur de champ magnétique (32) qui sont mobiles l'un par rapport à l'autre, le capteur de champ magnétique (31) ou le générateur de champ magnétique (32) se déplaçant avec le verrou (21), et **en ce que** le capteur de champ magnétique (31) enregistre toute altération du champ magnétique en fonction de la position du verrou (21).

7. Procédé selon la revendication 6,
**caractérisé en ce que**
le capteur de champ magnétique (31) enregistre une altération d'une composante X du champ magnétique dans une direction qui s'étend parallèlement à la direction du mouvement du verrou (21) et une altération d'une composante Y du champ magnétique dans une direction qui s'étend perpendiculairement à la direction du mouvement du verrou (21).

8. Procédé selon la revendication 7,
**caractérisé en ce que**
le dispositif de surveillance (30) enregistre une position de verrouillage du verrou (21) lorsqu'un extremum de la composante X et un point de symétrie de la composante Y sont détectés.

9. Procédé selon l'une quelconque des revendications 6 à 8,
**caractérisé en ce que**
le dispositif de surveillance (30) enregistre, au moyen d'une altération de la composante X et/ou d'une altération de la composante Y, la position du capteur de champ magnétique (31) par rapport au générateur de champ magnétique (32).

10. Procédé selon l'une quelconque des revendications 6 à 9,
**caractérisé en ce que**
le dispositif de surveillance (30) compare une altération de la composante X et/ou une altération de la composante Y avec des données caractéristiques afin de déterminer des différences.

11. Procédé selon la revendication 10,
**caractérisé en ce que**
le dispositif de surveillance détecte des champs étrangers lorsque les composantes mesurées du champ magnétique diffèrent des données caractéristiques en fonction de la position du verrou (21).

12. Procédé selon la revendication 10 ou 11,
**caractérisé en ce que**
le dispositif de surveillance détecte des changements de température dans le dispositif de protection d'accès lorsque les amplitudes des composantes mesurées du champ magnétique diffèrent des données caractéristiques.

13. Procédé selon l'une quelconque des revendications 6 à 12 pour faire fonctionner un dispositif de protection d'accès selon l'une quelconque des revendications 1 à 5.
